(19) Europäisches Patentamt / European Patent Office / Office européen des brevets

(11) **EP 2 803 985 B1**

(12) **FASCICULE DE BREVET EUROPEEN**

(45) Date de publication et mention
de la délivrance du brevet:
**14.03.2018  Bulletin 2018/11**

(51) Int Cl.:
*G01N 27/04* (2006.01)        *G01N 27/72* (2006.01)
*H01L 21/66* (2006.01)        *G01R 31/26* (2014.01)

(21) Numéro de dépôt: **14354008.6**

(22) Date de dépôt: **14.05.2014**

(54) **Détermination des concentrations en dopants accepteurs et donneurs**

Bestimmung der Konzentrationen an Akzeptor- und Donor-Dotiersubstanzen

Method for determining donor and acceptor dopant concentrations

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **14.05.2013  FR 1301104**

(43) Date de publication de la demande:
**19.11.2014  Bulletin 2014/47**

(73) Titulaire: **Commissariat à l'Energie Atomique et
aux Energies
Alternatives
75015 Paris (FR)**

(72) Inventeurs:
 • **Martel, Benoît**
   **F-73200 Gilly sur Isère (FR)**
 • **Veirman, Jordi**
   **F-74330 Poisy (FR)**

(74) Mandataire: **Talbot, Alexandre et al
Cabinet Hecké
28 Cours Jean Jaurès
38000 Grenoble (FR)**

(56) Documents cités:
**FR-A1- 2 978 549**

 • **STILLMAN G E ET AL: "Electrical
   characterization of epitaxial layers", THIN SOLID
   FILMS, ELSEVIER-SEQUOIA S.A. LAUSANNE,
   CH, vol. 31, no. 1-2, 1 janvier 1976 (1976-01-01),
   pages 69-88, XP025751092, ISSN: 0040-6090,
   DOI: 10.1016/0040-6090(76)90355-2 [extrait le
   1976-01-01]**
 • **KLEVELAND B ET AL: "Novel hall effect
   spectroscopy of impurity levels in
   semiconductors", SOLID STATE ELECTRONICS,
   ELSEVIER SCIENCE PUBLISHERS, BARKING,
   GB, vol. 33, no. 6, 1 juin 1990 (1990-06-01), pages
   743-752, XP024667209, ISSN: 0038-1101, DOI:
   10.1016/0038-1101(90)90188-K [extrait le
   1990-06-01]**

EP 2 803 985 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**Domaine technique de l'invention**

L'invention est relative à la détermination des teneurs en dopants dans un matériau semi-conducteur, et plus particulièrement dans un échantillon de silicium métallurgique destiné à l'industrie photovoltaïque.

**État de la technique**

Le silicium métallurgique purifié (« Upgraded Metallurgical Grade Silicon » en anglais, UMG-Si) est couramment utilisé dans l'industrie photovoltaïque. Il est préféré au silicium de qualité électronique (« Electronic Grade Silicon », EG-Si) car les procédés pour son élaboration sont moins coûteux et requièrent moins d'énergie. Cela permet de réduire le coût de fabrication des cellules photovoltaïques.

Le silicium métallurgique contient par contre plus d'impuretés que le silicium de qualité électronique. Les concentrations en dopants, en bore et en phosphore notamment, sont particulièrement élevées (plusieurs ppma).

Les atomes de bore constituent des impuretés dopantes de type accepteur tandis que les atomes de phosphore constituent des impuretés dopantes de type donneur. Puisque le silicium métallurgique contient les deux types d'impuretés dopantes, il est considéré comme compensé en impuretés dopantes.

La fabrication de cellules photovoltaïques à partir de plaques en UMG-Si nécessite un contrôle rigoureux des teneurs en dopants. En effet, les concentrations en dopants accepteurs et donneurs influent sur les propriétés électriques des cellules, comme le rendement de conversion.

Il paraît donc important de connaître les concentrations en dopants au sein du silicium, notamment pour déterminer si des étapes additionnelles de purification sont nécessaires. Il est également utile de connaître les concentrations en dopants au sein de la charge de silicium utilisée pour fabriquer un lingot de silicium. Ces informations permettent ensuite d'optimiser les procédés de fabrication des cellules photovoltaïques.

Les concentrations en dopants d'un échantillon de silicium sont classiquement déterminées par spectroscopie massique de décharge luminescente (« Glow Discharge Mass Spectroscopy », GDMS) ou par spectroscopie massique par plasma à couplage inductif (« Inductively Coupled Plasma Mass Spectrometry », ICPMS). Toutefois, ces techniques d'analyses chimiques sont lentes et manquent de précision pour les échantillons dont les teneurs en dopants sont faibles.

La détermination des concentrations en dopants peut aussi être réalisée par le fournisseur du lingot de silicium, à l'issue de sa cristallisation. Diverses techniques peuvent être employées.

Le document ["Ségrégation and crystallization of purified metallurgical grade silicon : Influence of process parameters on yield and solar cell efficiency", B. Drevet et al., 25th European PV Solar Energy Conférence and Exhibition, Valencia, 2010] décrit une méthode pour déterminer les concentrations en dopants dans un lingot de silicium métallurgique. Une étape consiste à détecter la transition entre une conductivité de type p et une conductivité de type n, qui apparaît à une certaine hauteur $h_{eq}$ dans le lingot. Puis, la résistivité électrique $\rho$ est mesurée à l'extrémité basse du lingot, c'est-à-dire dans la zone correspondant au début de la solidification. Les paramètres $h_{eq}$ et $\rho$ sont ensuite injectés dans une équation tirée de la loi de Scheil pour déterminer les profils de concentration dans le lingot.

Dans la demande de brevet FR2978548, on mesure la hauteur $h_{eq}$ du changement de type de conductivité (transition p-n) dans un lingot de silicium métallurgique et la concentration en porteurs de charge libres à l'extrémité basse du lingot. Des relations dérivées de la loi de Scheil permettent ensuite de déterminer les concentrations en dopants dans tout le lingot, connaissant les coefficients de ségrégation des dopants dans le silicium métallurgique. La demande de brevet FR2978549 décrite une méthode similaire. Ces techniques requièrent la solidification d'un lingot par cristallisation directionnelle. Elles ne sont donc pas applicables à des plaquettes de silicium. En outre, elles nécessitent de détecter précisément la transition entre le type p et le type n. Or, cette étape est difficilement reproductible à grande échelle, car la position de cette transition varie grandement d'un lingot à l'autre. Cette hauteur de transition peut également varier dans un même lingot, rendant plus imprécise l'extraction des teneurs en dopants.

Par ailleurs, l'article ["Electrical characterization of epitaxial layers", G. E. Stillman et al., Thin Solid Films, 31, 69-88, 1976] divulgue une technique pour déterminer les concentrations en atomes donneurs $N_D$ et atomes accepteurs $N_A$ dans un échantillon de GaAs de type n. Pour déterminer les concentrations $N_D$ et $N_A$, une expression théorique de la concentration en porteurs de charge en fonction de la température est ajustée à des valeurs expérimentales mesurées par effet Hall. Cette expression théorique fait intervenir l'énergie d'activation $E_D$ des donneurs, qui sont majoritaires dans un échantillon de type n.

Il arrive parfois que plusieurs espèces chimiques soient responsables d'un même type de dopage. Par exemple, un échantillon en silicium compensé peut contenir deux sortes de dopants accepteurs (dopage de type p), le bore et l'aluminium, et un dopant donneur, le phosphore (dopage de type n).

Dans ce cas, la technique de l'article susmentionné et celle de la demande FR2978548 ne permettent pas de déterminer les concentrations en aluminium et en bore indépendamment, seulement la concentration totale en impuretés de type accepteur. Autrement dit, on ne peut pas distinguer le bore de l'aluminium. En particulier, comme l'aluminium est une impureté à la fois dopante et métallique, elle présente un caractère recombinant et il est utile de connaître sa concentration propre, en vue de son élimination au cours de la purification.

De même, lorsque l'échantillon comprend plusieurs sortes de dopants donneurs, par exemple le phosphore et l'arsenic, il n'est pas possible d'isoler la concentration en phosphore et la concentration en arsenic.

**Résumé de l'invention**

Il existe ainsi un besoin de prévoir un procédé rapide et précis pour déterminer chacune des concentrations en dopants de type accepteur et donneur dans un échantillon en matériau semi-conducteur, lorsque celui-ci comprend plusieurs dopants d'un même type.

Plus particulièrement, on souhaite connaître les teneurs en dopants dans un échantillon muni de trois dopants, dont un de type majoritaire et un de type minoritaire, deux dopants d'un même type ayant des énergies d'activation différentes.

On tend à satisfaire ce besoin à l'aide des étapes suivantes :

- mesurer la concentration en porteurs de charge libres dans l'échantillon à des première et deuxième températures pour lesquelles le dopant du type majoritaire ayant la plus faible énergie d'activation est dans un régime d'ionisation ;

- confronter les mesures de la concentration en porteurs de charge libres avec un modèle mathématique de la concentration en porteurs de charge libres en fonction de la température dans le régime d'ionisation ;

- déterminer la valeur d'énergie d'activation du dopant de type majoritaire ayant la plus faible énergie d'activation et établir une première équation entre les concentrations en dopants, à partir des paramètres du modèle mathématique ;

- déterminer une valeur expérimentale de la mobilité des porteurs de charges majoritaires dans l'échantillon, préférentiellement à température ambiante ;

- comparer la valeur expérimentale de mobilité des porteurs de charges majoritaires à une expression théorique de la mobilité, de sorte à établir une deuxième équation entre les concentrations en dopants ; et

- comparer la valeur d'énergie d'activation du dopant de type majoritaire ayant la plus faible énergie d'activation à une valeur seuil de l'énergie d'activation pour ledit dopant.

Lorsque ladite valeur d'énergie d'activation est inférieure à la valeur seuil, les trois concentrations en dopants sont déterminées à partir de la plus faible énergie d'activation, et des première et deuxième équations.

Lorsque ladite valeur d'énergie d'activation est égale à la valeur seuil, les trois concentrations en dopants sont déterminées à partir des première et deuxième équations, d'une troisième équation dérivée de l'électro-neutralité dans le matériau semi-conducteur à température ambiante et de la concentration en porteurs de charge libres mesurée à température ambiante.

On appelle « dopant » une espèce chimique insérée dans le matériau semi-conducteur afin de modifier ses propriétés de conduction électrique. Les impuretés dopantes désignent les atomes de l'élément dopant.

Le dopage génère, dans le matériau semi-conducteur des porteurs de charge : des trous dans le cas d'un dopant de type accepteur et des électrons dans le cas d'un dopant de type donneur. Lorsque le nombre de trous générés est supérieur au nombre d'électrons, les trous sont dits « majoritaires » et les électrons « minoritaires ». Par extension, les dopants accepteurs sont qualifiés de type majoritaire et les dopants donneurs sont qualifiés de type minoritaire.

Inversement, lorsque le nombre de trous générés est inférieur au nombre d'électrons, les trous (dopants accepteurs) sont dits « minoritaires » et les électrons (dopants donneurs) « minoritaires ».

Enfin, l'expression « porteurs de charge libres » englobe à la fois les porteurs de charge majoritaires et les porteurs de charge minoritaires. La concentration en porteurs de charge libres correspond au dopage net : la différence entre la concentration en porteurs de charge majoritaires et la concentration en porteurs de charge minoritaires.

Le modèle mathématique de la concentration en porteurs de charge libres en fonction de la température dans le régime d'ionisation est, de préférence, une loi d'Arrhenius.

Si l'échantillon en matériau semi-conducteur comporte deux dopants majoritaires et un dopant minoritaire, le modèle peut s'écrire :

$$p_0(T) = C.\left[\frac{N_{MF} - N_m}{N_m}\right].e^{\frac{-E_{MF}}{kT}}$$

avec C un coefficient représentatif d'un type de conductivité des dopants majoritaires, $N_{MF}$ la concentration du dopant majoritaire dont l'énergie d'activation, $E_{MF}$, est la plus faible, $N_m$ la concentration du dopant minoritaire dans l'échantillon, k la constante de Boltzmann et T la température.

Si l'échantillon en matériau semi-conducteur comporte deux dopants minoritaires et un dopant majoritaire, le modèle peut s'écrire :

$$p_0(T) = C.\left[\frac{N_M - (N_{m1} + N_{m2})}{(N_{m1} + N_{m2})}\right].e^{\frac{-E_M}{kT}}$$

avec C un coefficient représentatif d'un type de conductivité du dopant majoritaire, $N_M$ la concentration du dopant majoritaire dans l'échantillon, $E_M$ l'énergie d'activation du dopant majoritaire, $N_{m1}$, $N_{m2}$ les concentrations des deux dopants minoritaires dans l'échantillon, k la constante de Boltzmann et T la température.

De préférence, la valeur expérimentale de la mobilité est déterminée à partir de la résistivité de l'échantillon mesurée à une troisième température et de la concentration en porteurs de charge libres mesurée à la troisième température.

Avantageusement, la concentration en porteurs de charge libres et la résistivité sont respectivement mesurées par effet Hall et par la méthode de Van der Pauw.

## Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :

- la figure 1 représente schématiquement les niveaux d'énergie introduits par deux dopants donneurs et deux dopants accepteurs dans la bande interdite du silicium ;

- la figure 2 représente des étapes d'un procédé de détermination des teneurs en dopants selon l'invention, appliqué à un échantillon contenant deux dopants accepteurs majoritaires et un dopant donneur minoritaire ;

- la figure 3 représente un mode de mise en oeuvre préférentiel de - l'étape F2 de la figure 2 ;

- la figure 4 représente l'énergie d'activation d'un dopant majoritaire en fonction de la concentration de ce dopant majoritaire, pour des échantillons en silicium de type n et de type p ;

- la figure 5 représente des étapes d'un procédé de détermination des teneurs en dopants selon l'invention, appliqué à un échantillon contenant un dopant accepteur majoritaire et deux dopants donneurs minoritaires ; et

- les figures 6 à 8 sont des exemples de courbes représentant le logarithme de la concentration en porteurs de charge libres, en fonction de l'inverse de la température.

## Description d'un mode de réalisation préféré de l'invention

Dans la description qui suit, on considère un échantillon en matériau semi-conducteur, par exemple en silicium métallurgique, comprenant trois espèces d'impuretés dopantes. Cet échantillon est compensé en impuretés dopantes. Autrement dit, au moins un dopant est de type accepteur d'électrons et au moins un dopant est de type donneur d'électrons.

Dans ces conditions, deux configurations sont possibles : soit l'échantillon comporte deux dopants accepteurs (le bore et l'aluminium par exemple) et un dopant de type donneur (ex. le phosphore ou l'arsenic), soit il comporte deux dopants donneurs et un dopant accepteur.

Les deux dopants d'un même type, accepteur ou donneur selon le cas, sont des espèces chimiques distinctes. Ils introduisent dans la bande interdite du silicium des niveaux d'énergie plus ou moins profond, définis par leur énergie d'activation électrique. Cette énergie d'activation permettra ultérieurement de les différencier.

Par ailleurs, lorsque la concentration en atomes accepteurs est supérieure à la concentration en atomes donneurs, toutes espèces confondues, les accepteurs sont appelés « majoritaires » et les donneurs sont appelés « minoritaires ». La conductivité de l'échantillon est alors de type p. Inversement, lorsque la concentration en atomes donneurs est supérieure à la concentration en atomes accepteurs, les dopants donneurs sont majoritaires devant les dopants accepteurs et l'échantillon est de type n.

Bien sûr, en présence d'un seul dopant accepteur (respectivement donneur), celui-ci peut quand même être majoritaire si la concentration de ce dopant est supérieure à la somme des deux concentrations en dopants donneurs (respectivement accepteurs).

Ainsi, deux autres cas se dessinent, pour chaque répartition des dopants donneurs et accepteurs, en fonction du type de conductivité de l'échantillon qui résulte du dopage.

Quels que soient la nature des dopants et le type de conductivité, les trois concentrations en dopants de l'échantillon peuvent être déterminées en résolvant un système de trois équations faisant intervenir leurs concentrations respectives.

Une première équation est obtenue en mesurant la concentration en porteurs de charge libres de l'échantillon (les trous dans le type p, les électrons dans le type n) à basse température, puis en confrontant ces mesures à un modèle mathématique adapté à ces températures.

De façon similaire, une deuxième équation est obtenue en mesurant la mobilité des porteurs de charge majoritaires et en la comparant à son expression théorique.

Enfin, une troisième condition sur les concentrations en dopants peut être établie connaissant l'énergie d'activation du dopant majoritaire le moins profond dans la bande interdite du matériau semi-conducteur. Lorsque l'énergie d'activation de ce dopant majoritaire est égale à sa valeur maximale, cette troisième condition repose sur l'électroneutralité du silicium à température ambiante. Par contre, lorsque l'énergie d'activation diffère de sa valeur maximale, la concentration de ce dopant majoritaire peut être directement déduite de son énergie d'activation.

Ce procédé de détermination des teneurs en dopants est décrit en détail ci-après, dans les différents cas explicités ci-dessus.

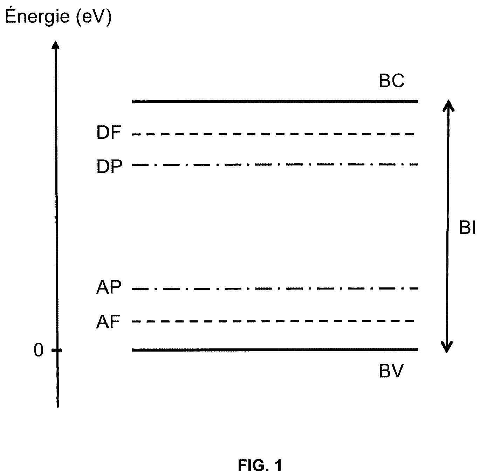

Pour commencer, la figure 1 illustre la notion de dopant plus ou moins profond par un diagramme de bande.

Le cas d'un silicium comprenant deux dopants donneurs est représenté en haut du diagramme, à proximité de la bande de conduction BC. Le dopant donneur le moins profond, noté « DF », est celui dont le niveau d'énergie (représenté en traits pointillés) introduit dans la bande interdite BI du silicium est le plus proche de la bande de conduction. Le dopant « DP » est un dopant donneur plus profond, car son niveau d'énergie (représenté en traits mixte) est davantage éloigné de la bande de conduction BC.

De façon similaire, pour deux dopants accepteurs « AF » et « AP », le dopant accepteur le moins profond « AF » est celui dont le niveau d'énergie est le plus proche de la bande de valence. Ce niveau d'énergie est représenté en traits pointillés, en bas du diagramme de bande de la figure 1. « AP » désigne le dopant dont le niveau d'énergie est introduit profondément dans le gap du silicium (en trait mixte).

L'énergie d'activation d'un dopant donneur (respectivement accepteur) correspond à la différence d'énergies (en eV) entre la bande de conduction (respectivement la bande de valence) et le niveau d'énergie du dopant. Les énergies d'activation des dopants accepteurs et donneurs ont ci-après des valeurs positives (la bande de valence définit l'origine de l'axe des énergies sur la figure 1).

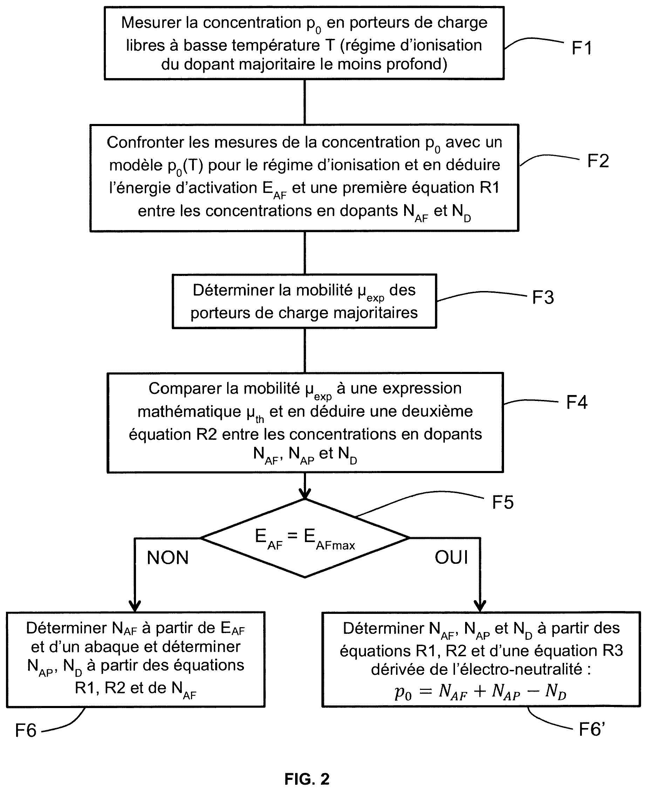

La figure 2 représente un mode de mise en oeuvre du procédé de détermination des teneurs en dopants, dans le cas d'un silicium de type p contenant un dopant donneur, par exemple le phosphore, et deux dopants accepteurs, par exemple le bore et l'aluminium.

$N_{AF}$ et $E_{AF}$ désignent respectivement la concentration et l'énergie d'activation du dopant accepteur ayant le niveau le moins profond, i.e. l'énergie d'activation ayant la valeur la plus faible (le bore dans l'exemple ci-dessus). $N_{AP}$ est la concentration du dopant accepteur ayant la valeur d'énergie d'activation, $E_{AP}$, la plus élevée (ex. l'aluminium). Enfin, la concentration en atomes donneurs (ex. le phosphore) dans l'échantillon en silicium est notée $N_D$.

Dans une première étape F1 du procédé de détermination, on mesure à basse température la concentration $p_0$ en porteurs de charges libres (dopage net).

Dans un silicium de type p, les porteurs de charges libres sont des trous. Leur nombre est donné par la relation :

$$p_0 = \sum N_A^{\ -} - N_D^{\ +} \qquad (1)$$

dans laquelle $N_A^-$ est la concentration en atomes ionisés de chaque dopant accepteur (bore et aluminium) et $N_D^+$ est la concentration en atomes donneurs ionisés (phosphore).

Lorsque la température de l'échantillon en silicium diminue, les dopants majoritaires, ici les accepteurs, sont progressivement « gelés ». Les atomes accepteurs deviennent électriquement inactifs, car l'énergie thermique ne suffit plus à ioniser ces impuretés. On considère par contre que les dopants minoritaires, ici les donneurs, sont tous actifs, quelle que soit la température de l'échantillon ($N_D^+ = N_D$).

Le gel des dopants majoritaires s'effectue par paliers de températures, en fonction des niveaux en énergie introduits par les impuretés dans la bande interdite du silicium. A basse température, les impuretés de type accepteur dont le niveau d'énergie est profond sont neutralisées, car l'énergie thermique nécessaire à leur ionisation est importante. Puis, à très basse température, les atomes accepteurs dont le niveau d'énergie est moins profond sont à leur tour neutralisés.

L'étape de mesure F1 de la figure 2 est réalisée à basse température pour écarter temporairement le dopant accepteur de plus forte énergie $E_{AP}$ du calcul de la concentration en trous $p_0$ (relation 1). Cela permet d'établir une relation liant uniquement la concentration $N_{AF}$ et la concentration $N_D$ à la concentration en trous $p_0$. En effet, dans cette gamme de températures, la concentration des atomes accepteurs ionisés et profonds est nulle. La concentration en trous $p_0$ de la relation (1) devient égale à la différence de la concentration des atomes accepteurs peu profonds ionisés, qu'on notera $N_{AF}^-$, et de la concentration en atomes donneurs $N_D$ :

$$p_0 = N_{AF}^- - N_D \qquad (1').$$

A l'étape F1, la concentration en trous $p_0$ est mesurée à au moins deux températures pour lesquelles le dopant accepteur peu profond, en l'occurrence le bore, est dans un régime d'ionisation. Ce régime est caractérisé par une ionisation partielle, et non totale, des atomes de bores. La concentration en atomes de bore ionisés $N_{AF}^-$ est alors inférieure à la concentration en atomes de bore $N_{AF}$ et varie en fonction de la température T.

L'effet Hall est, de préférence, utilisé pour la mesure de la concentration en porteurs de charge libres. La mesure par effet Hall permet d'abord de déterminer la concentration en porteurs de Hall $p_H$ à partir d'une mesure de tension. Puis, la concentration $p_0$ est calculée à partir de la concentration $p_H$ en appliquant un coefficient correcteur $r_H$ appelé facteur de hall.

A l'étape F2, les mesures de la concentration $p_0$ sont confrontées à un modèle mathématique $p_0(T)$ spécifique à ce régime d'ionisation.

Le modèle $p_0(T)$ utilisé est, de préférence, une loi d'Arrhenius dérivée de la relation (1') et de la statique de Fermi-Dirac. Il s'écrit sous la forme $A.e^{\frac{-B}{kT}}$ :

$$p_0(T) = \frac{1}{4} . N_V . \left[ \frac{N_{AF} - N_D}{N_D} \right] . e^{\frac{-E_{AF}}{kT}}$$

Le facteur pré-exponentiel $A = \frac{1}{4} . N_V . \left[ \frac{N_{AF} - N_D}{N_D} \right]$ tient compte de la concentration $N_{AF}$ en atomes accepteurs peu profonds, de la concentration $N_D$ en atomes donneurs (tous ionisés) et de la densité d'état $N_V$ dans la bande de valence. Le paramètre B figurant dans l'exponentielle équivaut à l'énergie d'activation $E_{AF}$ du dopant accepteur peu profond.

Le recoupement des valeurs expérimentales de la concentration $p_0$ avec l'expression théorique ci-dessus (étape F2) fixe une valeur à chacun des paramètres A et B du modèle. On en déduit, d'une part, une première équation R1 liant des teneurs en dopants $N_{AF}$ et $N_D$ (l'expression du facteur A), et d'autre part, l'énergie d'activation $E_{AF}$ (facteur B).

Compte tenu que le modèle $p_0(T)$ est une loi d'Arrhenius, une façon simple et rapide de mettre en oeuvre l'étape F2 peut consister à étudier la relation linéaire entre le logarithme de la concentration en porteurs de charge libres $p_0$ et l'inverse de la température T.

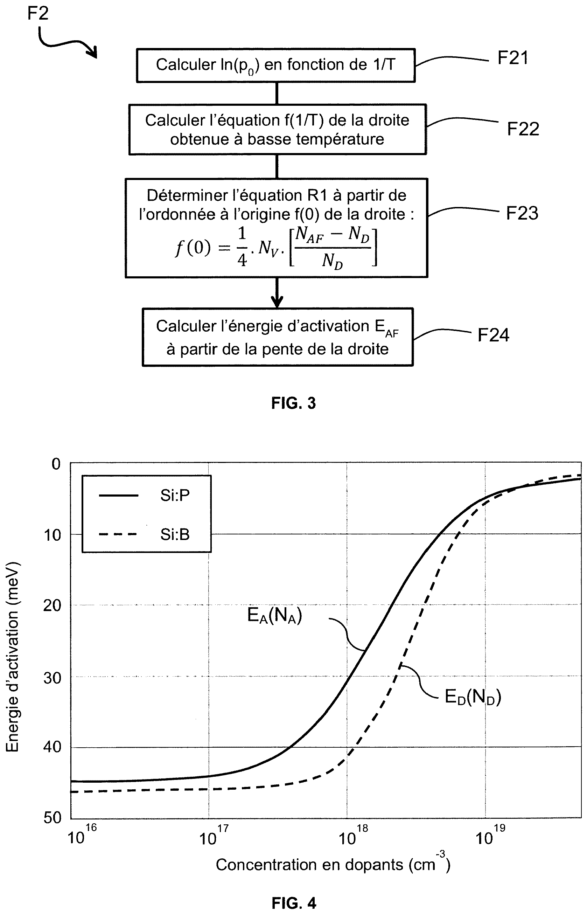

La figure 3 représente, au travers des étapes F21 à F24, ce mode de mise en oeuvre avantageux de l'étape F2.

En F21, le logarithme de la concentration $p_0$ en fonction de l'inverse de la température T est calculé pour les différentes valeurs de $p_0$ mesurées à l'étape F1.

A l'étape F22, on calcule l'équation y = f(x) d'une droite représentant le logarithme de la concentration $p_0$ dans le régime d'ionisation du dopant accepteur peu profond. On dispose alors de deux informations : l'ordonnée à l'origine f(0), qui contient les concentrations $N_{AF}$ et $N_D$, et la pente de cette droite qui est proportionnelle à l'énergie d'activation $E_{AF}$.

L'équation R1 peut être déduite directement de l'ordonnée à l'origine f(0) (étape F23) :

$$(R1) \qquad f(0) = \frac{1}{4} . N_V . \left[ \frac{N_{AF} - N_D}{N_D} \right]$$

En F24, l'énergie d'activation $E_{AF}$ est calculée en divisant la pente de la droite par la constante de Boltzmann k.

Bien que deux mesures en température dans le régime d'ionisation suffisent à l'établissement de l'équation R1, il peut être préférable d'effectuer une multitude de mesures dans une plus grande plage de températures, notamment une mesure à la température ambiante.

Le procédé de détermination de la figure 2 comprend également une étape F3 de détermination de la mobilité $\mu_{exp}$ des porteurs de charge majoritaires dans l'échantillon (Fig.1). Pour établir la deuxième équation entre les teneurs en dopants $N_{AF}$, $N_{AP}$ et $N_D$, la valeur mesurée de la mobilité est comparée, lors d'une étape F4, à une expression mathématique $\mu_{th}$ de la mobilité qui fait intervenir les concentrations $N_{AF}$, $N_{AP}$ et $N_D$.

L'expression mathématique de la mobilité $\mu_{th}$ peut être déterminée en se basant sur un modèle théorique issu d'une théorie scientifique. Dans ce cas, on peut parler d'expression théorique. Par ailleurs, cette expression mathématique peut être déterminée à partir de valeurs basées sur des travaux expérimentaux. Autrement dit, l'expression mathématique de la mobilité peut également être obtenue de manière empirique ou semi-empirique.

La mobilité dépend de la concentration en porteurs de charge libres $p_0$ et de la résistivité p de l'échantillon de la façon suivante :

$$\mu(T) = \frac{1}{p_0(T).\,q.\,\rho(T)}$$

q étant la charge électrique élémentaire (q = 1,6.10$^{-19}$ C)

Ainsi, dans un mode de mise en oeuvre préférentiel de l'étape F3, la valeur $\mu_{exp}$ de la mobilité est calculée à partir de la résistivité p de l'échantillon et de la concentration $p_0$ mesurées à une même température.

Si l'on souhaite réutiliser l'une des précédentes mesures de la concentration $p_0$ (celles de l'étape F1), la résistivité p est mesurée à l'une des températures correspondant au régime d'ionisation. Cela nécessitera par contre une nouvelle mise en froid de l'échantillon, à moins que la résistivité p n'ait été mesurée en même temps que la concentration $p_0$ lors de l'étape F1, ce qui est généralement le cas.

Il peut donc être plus commode de réaliser la mesure de résistivité à une autre température, à la température ambiante notamment. Ainsi, dans une variante de mise en oeuvre, la résistivité p et la concentration en trous $p_0$ de l'échantillon sont toutes les deux mesurées à la température ambiante.

De préférence, la technique utilisée pour mesurer la résistivité p est la technique de Van der Pauw. Néanmoins, d'autres techniques de mesure de la résistivité pourraient être envisagées : par courant de Foucault ou par la méthode des « quatre pointes ».

Les variations de la mobilité des porteurs majoritaires en fonction des teneurs en dopants dans le silicium compensé ont fait l'objet de nombreuses études et plusieurs modèles de mobilité ont été proposés. Par exemple, les auteurs de l'article ["Modeling majority carrier mobility in compensated crystalline silicon for solar cells", F. Schindler et al., Solar Energy Materials & Solar Cells, vol. 106, pp.31-36, 2012] ont développé le modèle suivant :

$$\mu_{th} = \mu_{min} + \frac{\mu_{max} - \mu_{min}}{1 + \left(\dfrac{N}{N_{réf}}\right)^{\alpha} + \left(\dfrac{C_l - 1}{C_{l,réf}}\right)^{\beta}}$$

avec $\mu_{min}$, $\mu_{max}$, $N_{ref}$, $\alpha$, $\beta$, $C_{l,réf}$ des constantes du modèle. N est la somme des concentrations en dopants (N = $N_{AF}$ + $N_{AP}$ + $N_D$). $C_l$ est le degré de compensation tel que défini par la relation :

$$C_l = \frac{N}{N_{AF} + N_{AP} - N_D}$$

Ce modèle, développé dans le cadre d'un silicium de type p compensé, peut aisément être adapté au cas du silicium type n. Alternativement, d'autres modèles de la littérature pourraient être utilisés dans le procédé de détermination (à condition qu'ils fassent intervenir les trois teneurs en dopants).

A l'étape F4 de la figure 2, la valeur expérimentale $\mu_{exp}$ de la mobilité est mise en équation avec son expression mathématique $\mu_{th}$. On obtient alors une deuxième équation R2 liant les concentrations en dopants $N_{AF}$, $N_{AP}$ et $N_D$ (au travers de la concentration totale en dopants N et du degré de compensation $C_l$) :

$$(R2) \qquad \mu_{exp} = \mu_{min} + \frac{\mu_{max} - \mu_{min}}{1 + \left(\dfrac{N}{N_{réf}}\right)^{\alpha} + \left(\dfrac{C_l - 1}{C_{l,réf}}\right)^{\beta}}$$

La troisième condition permettant de déterminer les concentrations $N_{AF}$, $N_{AP}$ et $N_D$ dépend de la valeur de l'énergie d'activation $E_{AF}$ calculée à l'étape F2. En effet, il a été démontré dans le document ["A simulation model for the density of states and for incomplète ionization in crystalline silicon - Part II", P.P. Altermatt et al., J. Appl. Phys. 100, 113715, 2006] que l'énergie d'activation des impuretés majoritaires varie en fonction de la concentration $N_A$ de ces impuretés majoritaires.

La figure 4 représente cette variation de l'énergie d'activation dans le cas d'un silicium dopé majoritairement au bore (type p), c'est-à-dire l'énergie des dopants accepteurs $E_A$ en fonction de la concentration en accepteurs $N_A$, et dans le cas d'un silicium dopé majoritairement au phosphore (type n), soit la fonction $E_D(N_D)$.

On remarque sur la figure 4 que l'énergie d'activation $E_A$ du dopant accepteur atteint une valeur maximale $E_{Amax}$ lorsque la concentration en dopant $N_A$ est faible. Par contre, au delà d'un certain seuil de concentration $N_A$, d'environ $10^{17}$ atomes/cm$^{-3}$ de bore, elle diminue. Cela est dû au fait que le niveau d'énergie introduit par les impuretés majoritaires passe d'un état discret à un état de bande, lorsque la concentration en dopants augmente. Cette bande se rapproche de la bande de valence.

Ce constat est également valable pour le type n, comme cela est représenté sur la figure 4 (à la différence que le niveau d'énergie « de bande » se rapproche de la bande de conduction).

En outre, P.P. Altermatt et al. ont montré que le taux d'ionisation des impuretés majoritaires à température ambiante (environ 300 K) avoisine 100 % pour les concentrations $N_A$ du plateau $E_A = E_{Amax}$ de la figure 4, c'est-à-dire pour les concentrations inférieures à $10^{17}$ cm$^{-3}$.

Dans le procédé selon la figure 2, ces constats sont mis en application pour obtenir une troisième information sur les teneurs en dopants.

Lorsque l'énergie d'activation $E_{AF}$ calculée à l'étape F2 diffère de la valeur seuil $E_{AFmax}$, il n'existe, sur le graphe de la figure 4, qu'une seule valeur possible pour la concentration $N_{AF}$ correspondante. Ainsi, lorsque cette condition est vérifiée, la concentration $N_{AF}$ en dopants accepteurs peu profonds peut être déterminée directement à l'aide d'un abaque comme celui de la figure 4.

Par contre, lorsque l'énergie d'activation $E_{AF}$ est égale à la valeur seuil $E_{AFmax}$, on ne peut utiliser la dépendance entre $E_{AF}$ et $N_{AF}$ illustrée par la figure 4, car il existe une pluralité de concentrations $N_{AF}$ correspondant à l'énergie $E_{AFmax}$ (zone du plateau). A la place, on utilise la loi d'électro-neutralité donnée par la relation (1) à la température ambiante, en supposant une ionisation complète des dopants accepteurs (et donneurs).

En effet, lorsque l'hypothèse d'une ionisation complète à température ambiante se justifie ($E_{AF} = E_{AFmax}$), la relation suivante s'applique :

$$(R3) \qquad p_0(T_{ambiante}) = N_{AF} + N_{AP} - N_D$$

Autrement dit, alors que P.P. Altermatt ne fait que constater une ionisation complète des impuretés majoritaires à température ambiante, le procédé de détermination utilise ce constat comme hypothèse de travail pour développer une troisième équation R3 entre les teneurs en dopants.

Dans le procédé selon la figure 2, une étape F5 est prévue pour comparer la valeur de l'énergie d'activation $E_{AF}$ calculée à l'étape F2 à sa valeur seuil $E_{AFmax}$.

Si l'énergie d'activation $E_{AF}$ diffère de $E_{AFmax}$ (sortie NON de l'étape F5), on détermine, dans une étape F6, la concentration en accepteurs peu profonds $N_{AF}$ comme indiqué ci-dessus, puis la concentration en donneurs $N_D$ à l'aide de l'équation R1 et enfin, la concentration en accepteurs profonds $N_{AP}$ à l'aide de l'équation restante R2.

Si l'énergie d'activation $E_{AF}$ est égal à $E_{AFmax}$ (sortie OUI en F5), on obtient alors, avec l'équation R3 ci-dessus, un système de trois équations à trois inconnues qui peut être résolus facilement, par exemple par ordinateur (étape F6').

Bien que les étapes F1 à F4 paraissent être successives sur la figure 2, le procédé de détermination des teneurs en dopants n'est limité à aucun ordre particulier de ces étapes. Par exemple, les étapes F1 et F3 de mesures peuvent être réalisées simultanément.

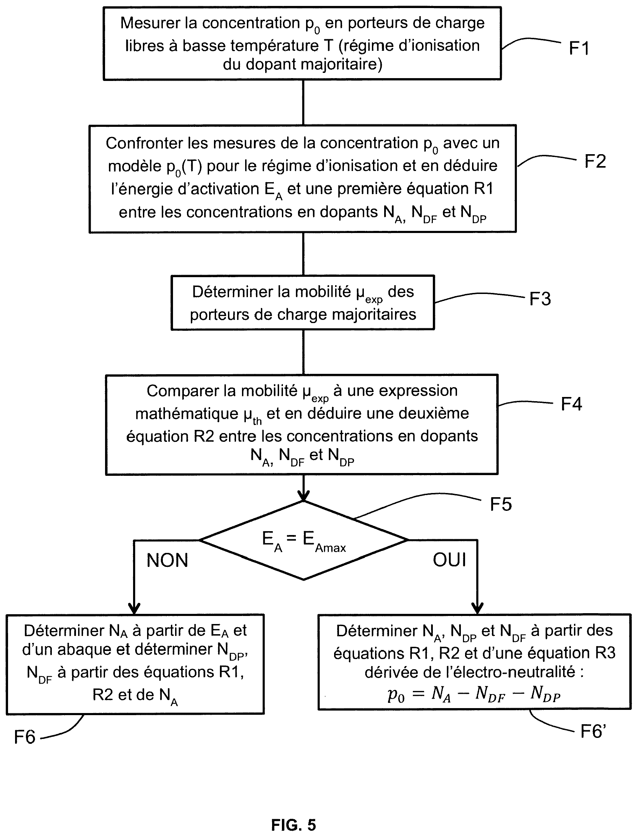

La figure 5 représente une variante de mise en oeuvre du procédé de détermination des teneurs en dopants, dans le cas d'un silicium de type p contenant désormais un seul dopant accepteur, mais deux dopants donneurs.

La concentration et l'énergie du seul dopant accepteur (mais majoritaire) y sont notées $N_A$ et $E_A$. Les deux dopants donneurs, de concentrations $N_{DF}$, $N_{DP}$ seront différenciés par leur énergie d'activation : $E_{DP}$ pour l'énergie la plus grande (dopants profonds) et $E_{DF}$ pour l'énergie la plus faible (dopants moins profonds).

Cette variante établit et résout des équations entre les concentrations en dopants $N_A$, $N_{DF}$ et $N_{DP}$ de la même manière que selon le mode de la figure 2. Les étapes du procédé de la figure 5 sont donc, en substance, les mêmes que celles de la figure 2. Seule l'écriture des équations R1 à R3 diffèrent.

Les deux dopants donneurs sont minoritaires dans le type p. Ils sont par conséquent tous ionisés, quelle que soit la température. La concentration en trous $p_0$ s'écrit alors :

$$p_0 = N_A{}^- - N_{DF} - N_{DP}$$

Les mesures de la concentration $p_0$ pour des températures correspondant au régime d'ionisation du seul dopant accepteur (étape F1) sont confrontés à un modèle mathématique adapté à ce nouveau cas d'espèce (étape F2), qui est le suivant :

$$p_0(T) = \frac{1}{4} \cdot N_V \cdot \left[ \frac{N_A - N_{DF} - N_{DP}}{N_{DF} + N_{DP}} \right] \cdot e^{\frac{-E_A}{kT}}$$

La première équation peut être, comme précédemment, tirée du logarithme de la concentration en trous $p_0$ (l'ordonnée à l'origine de la droite) et s'écrit désormais :

$$(R1) \qquad f(0) = \frac{1}{4} \cdot N_V \cdot \left[ \frac{N_A - N_{DF} - N_{DP}}{N_{DF} + N_{DP}} \right]$$

La deuxième équation est, comme précédemment, obtenue en comparant la valeur expérimentale de la mobilité avec une expression mathématique $\mu_{th}$ (étapes F3-F4). Cette expression est similaire à la précédente. Seul le degré de compensation $C_l$ doit être redéfini :

$$C_l = \frac{N}{N_A - N_{DP} - N_{DF}}$$

avec désormais

$$N = N_A + N_{DP} + N_{DF}.$$

Enfin, selon la valeur de l'énergie d'activation $E_A$ du dopant accepteur majoritaire (étape F5), on utilise soit un abaque $E_A(N_A)$ pour en déduire directement la concentration $N_A$ (étape F6), soit, connaissant la valeur de la concentration en trous $p_0$ à la température ambiante, l'équation d'électro-neutralité à température ambiante (étape F6') :

$$(R3) \qquad p_0(T_{ambiante}) = N_A - N_{DF} - N_{DP}$$

Pour un silicium compensé de type n (dopants donneurs majoritaires), le procédé de détermination s'appliquera à l'identique, sauf bien sûr en ce qui concerne l'écriture des équations entre les différentes teneurs en dopants. En outre, à l'étape F1, on ne mesure plus la concentration en trous $p_0$, mais la concentration en électrons $n_0$ (les électrons sont majoritaires). Aux étapes F3 et F5, on considère l'énergie d'activation $E_D$ (ou $E_{DF}$ s'il y en a deux) du dopant donneur qui n'est pas gelé à basse température.

Le tableau 1 ci-dessous regroupe toutes les équations nécessaires à la détermination des concentrations en dopants pour un silicium de type n. A nouveau, on peut distinguer deux cas :

- deux dopants accepteurs et un dopant donneur : {$N_{AF}$, $N_{AP}$, $N_D$} ; ou

- deux dopants donneurs et un dopant accepteur : {$N_A$, $N_{DF}$, $N_{DP}$}.

**Tableau 1**

| | | {$N_{AF}$, $N_{AP}$, $N_D$} | {$N_A$, $N_{DF}$, $N_{DP}$} |
|---|---|---|---|
| R1 | | $$n_0(T) = \frac{1}{2} \cdot N_C \cdot \left[ \frac{N_D - N_{AF} - N_{AP}}{N_{AF} + N_{AP}} \right] \cdot e^{\frac{-E_D}{kT}}$$ avec $N_C$ la densité d'état dans la bande de conduction | $$n_0(T) = \frac{1}{2} \cdot N_C \cdot \left[ \frac{N_{DF} - N_A}{N_A} \right] \cdot e^{\frac{-E_{DF}}{kT}}$$ avec $N_C$ la densité d'état dans la bande de conduction |
| R2 | | $$\mu_{exp} = \mu_{min} + \frac{\mu_{max} - \mu_{min}}{1 + \left(\frac{N}{N_{réf}}\right)^{\alpha} + \left(\frac{C_l - 1}{C_{l,réf}}\right)^{\beta}}$$ avec $N = N_D + N_{AF} + N_{AP}$ et $$C_l = \frac{N}{N_D - N_{AP} - N_{AF}}$$ | $$\mu_{exp} = \mu_{min} + \frac{\mu_{max} - \mu_{min}}{1 + \left(\frac{N}{N_{réf}}\right)^{\alpha} + \left(\frac{C_l - 1}{C_{l,réf}}\right)^{\beta}}$$ avec $N = N_{DF} + N_{DP} + N_A$ et $$C_l = \frac{N}{N_{DF} + N_{DP} - N_A}$$ |
| R3 | | $n_0(T_{amb}) = N_D - N_{AF} - N_{AP}$ | $n_0(T_{amb}) = N_{DF} + N_{DP} - N_A$ |

Le modèle de mobilité de F. Schindler et al. (relation R2) est également applicable au type n, à condition d'ajuster les valeurs des paramètres $\mu_{min}$, $\mu_{max}$, $N_{ref}$, $\alpha$, $\beta$, $C_{l,réf}$.

Le procédé décrit ci-dessus détermine de façon fiable et précise les teneurs en dopants d'un échantillon semi-conducteur. A la différence des techniques de l'art antérieur, il permet de faire la distinction entre plusieurs espèces dopantes responsables d'un même type de dopage. En outre, il s'applique à toutes les formes d'échantillons, notamment de lingot ou de plaques. Les différentes étapes de calcul du procédé de détermination peuvent être réalisées au moyen d'un ordinateur, et plus particulièrement par un microprocesseur.

Ces différentes concentrations en dopants constituent de précieuses informations pour optimiser les procédés de fabrication des dispositifs semiconducteurs. En particulier, la fabrication de cellules photovoltaïques à haut rendement en silicium métallurgique est facilitée, car il est désormais possible de contrôler efficacement leurs teneurs en dopants.

Afin d'être plus précis sur la détermination de l'énergie d'activation du dopant majoritaire peu profond ($E_A$/$E_{AF}$ ou $E_{DF}$/$E_D$ selon le type de dopage) et de la relation R1, on peut prendre en compte la variation en température du paramètre $N_V$ ou $N_C$. Les densités d'états $N_V$ et $N_C$ sont des fonctions de la température T, en $T^{3/2}$ quel que soit le type de semi-conducteur et de dopage. On tracera alors le logarithme de la concentration p(T) multiplié par $T^{-3/2}$ pour tenir compte de cette dépendance.

Comme indiqué précédemment, le régime d'ionisation du dopant majoritaire le moins profond correspond à une certaine plage de températures. Cette plage de températures varie selon la nature des dopants, leur concentration et bien sûr, le matériau semi-conducteur.

On constate que la limite haute de cette plage, c'est-à-dire la température à laquelle on passe d'un régime de saturation du dopant majoritaire à un régime d'ionisation, augmente plus la concentration en dopants majoritaires est élevée. En outre, elle augmente plus l'échantillon est compensé. Ceci est valable à la fois pour un semi-conducteur dopé de type n et pour un semi-conducteur dopé de type p.

Pour un matériau et un dopage donnés, la limite haute de la plage de températures peut être déterminée expérimentalement en traçant le logarithme de la concentration en porteurs de charge libres, en fonction de l'inverse de la température, et en observant à quelle température la courbe bascule d'un comportement hyperbolique à un comportement linéaire. Elle peut également être déterminée numériquement, en calculant la variation des porteurs en fonction de la température (grâce notamment à la relation 1).

La limite basse de la plage correspond à l'apparition d'un phénomène de conduction appelé « hopping ». En effet, à très basse température, la conduction des électrons dans la bande de conduction (ou des trous dans la bande de valence) devient si improbable qu'elle laisse place à un autre mécanisme : le saut des porteurs de charge entre des états d'énergie localisés dans la bande interdite du silicium. Les porteurs de charges « sautent » d'atome en atome, parmi les dopants majoritaires ionisés.

Ainsi, la limite basse de température correspond à la transition entre le régime de conduction de bande (régime de gel des dopants profonds) et le régime de conduction par « hopping ». Elle peut être déterminée en traçant le logarithme de la concentration en porteurs de charge libres et en observant un deuxième comportement hyperbolique, à très basse température. Alternativement, elle peut être déterminée en traçant la courbe de résistivité en loi d'Arrhenius (résistivité en fonction de l'inverse de la température) et en relevant la température à laquelle le régime linéaire prend fin (par exemple en faisant une régression linéaire).

Lorsque la concentration en porteurs de charge libres est mesurée par effet Hall, la limite basse en température est avantageusement déterminée en traçant la courbe du coefficient de Hall $\left(R_H = \frac{1}{p_0(T).q}\right)$ en fonction de l'inverse de la température, puis en repérant la fin du régime linéaire.

Dans les exemples qui suivent, les teneurs en dopants accepteurs et donneurs obtenues par le procédé selon l'invention sont comparées aux valeurs obtenues par la méthode classique de spectroscopie massique de décharge luminescente (« Glow Discharge Mass Spectroscopy », GDMS).

**Exemple 1**

Dans ce premier exemple, l'échantillon est en silicium compensé de type p. Il contient deux espèces dopantes de type accepteur, du bore et du gallium, et une espèce dopante de type donneur, du phosphore.

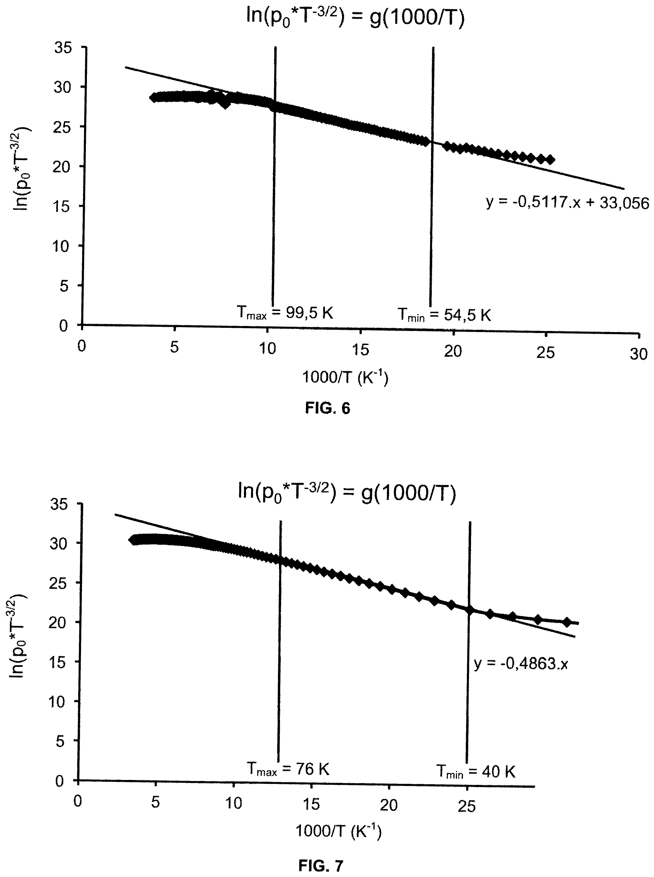

La concentration en trous $p_0$ est mesurée par effet Hall dans la gamme de températures 40 K-300 K. Les valeurs du logarithme de la concentration en trous $\ln(p_0)^*T^{-3/2}$ sont portées sur le graphe de la figure 6 en fonction de l'inverse de la température 1000/T. La courbe du logarithme présente une portion linéaire à partir d'un seuil de température $T_{max}$, qui est estimé par régression linéaire ($T_{max}$ = 99,5 K). Le régime linéaire prend fin à la température $T_{min}$, également estimée par régression linéaire ($T_{min}$ = 54,5 K).

Ainsi, une droite est obtenue dans la gamme de températures 54,5 K-99,5 K (les valeurs de $T_{max}$ et $T_{min}$ correspondent à de brusques variations du coefficient de régression linéaire). Son équation est la suivante : y = - 0,512.x + 33,06.

D'une part, la pente de la droite permet de calculer l'énergie d'activation $E_{AF}$ du bore, qui introduit le plus faible niveau d'énergie dans la bande interdite du silicium : $E_{AF}$ = 44 meV.

L'ordonnée à l'origine permet de calculer le rapport de la concentration en bore sur la concentration en phosphore :

$$\ln\left[\frac{1}{4}.N_V'.\left(\frac{[B]-[P]}{[P]}\right)\right] = 33,06$$

$N_V'$ est une densité d'état dans la bande de valence dont la contribution en température a été supprimée par le tracé de $\ln(p_0^*T^{-3/2})$ : $N_V = N_V'.T^{3/2}$, avec $N_V'$ = 3.5.$10^{15}$ cm$^{-3}$.

La concentration en trous à température ambiante (300 K) vaut 1,1.$10^{16}$ cm$^{-3}$. Après avoir mesuré la résistivité de l'échantillon, on en déduit la mobilité $\mu_{exp}$ des trous à température ambiante :

$$\mu_{exp} = \mu_{min} + \frac{\mu_{max} - \mu_{min}}{1 + \left(\frac{N}{N_{réf}}\right)^\alpha + \left(\frac{C_l - 1}{C_{l,réf}}\right)^\beta} = 308,52\ cm^2.V^{-1}.s^{-1}$$

Comme la valeur de 44 meV est très proche du niveau stable et discret du bore dans la bande interdite du silicium (45 meV), l'hypothèse d'un taux de ionisation avoisinant 100 % à température ambiante est valable. Cela permet d'utiliser l'équation d'électro-neutralité comme troisième et dernière équation :

$$[B] + [Ga] - [P] = 1,1.10^{16}\ cm^{-3}$$

Les concentrations en dopants, calculées en résolvant les trois équations ci-dessus (étape F6'), sont reportées dans le tableau 2 suivant en comparaison avec les valeurs mesurées par GDMS :

**Tableau 2**

|  | Procédé | GDMS |
|---|---|---|
| [B] | 3,01.$10^{16}$ | 2,54.$10^{16}$ |

(suite)

|  | Procédé | GDMS |
|---|---|---|
| [Ga] | $5,67.10^{15}$ | $6,75.10^{15}$ |
| [P] | $2,41.10^{15}$ | $2,22.10^{16}$ |

Il existe une forte adéquation entre les valeurs mesurées par analyse chimique GDMS et celles obtenues par le procédé de détermination de la figure 1.

Exemple 2

Dans ce deuxième exemple, l'échantillon est également en silicium compensé de type p, mais comporte de l'aluminium à la place du gallium.

La concentration en trous $p_0$ est mesurée, également par effet Hall, dans la gamme de températures 30 K-300 K et la résistivité de l'échantillon est mesurée à 300 K. La courbe $\ln(p_0)*T^{-3/2}$ en fonction de 1000/T, représentée sur la figure 7, présente dans la plage 40 K-76 K une droite d'équation : $y = -0,486.x + 34,41$.

L'énergie d'activation $E_{AF}$ vaut alors 41,8 meV, ce qui est plus faible que la valeur maximale de l'énergie d'activation constatée pour le bore (45 meV). La valeur de la concentration en bore est, dans ce cas, obtenue directement à l'aide d'un abaque $E_{AF}(N_{AF})$, tel que celui de la figure 3 :

$$[B] = 1,11.10^{17} \ cm^{-3}$$

Connaissant l'ordonnée à l'origine de la droite et la concentration en bore, on détermine la concentration en phosphore :

$$[P] = \frac{[B]}{\frac{4.e^{34.41}}{Nv'} + 1} = 5,64.10^{16} \ cm^{-3}$$

Enfin, la valeur de la mobilité des porteurs majoritaires à température ambiante est estimée à 260,5 cm$^2$.V$^{-1}$.s$^{-1}$. L'expression mathématique $\mu_{th}$ de la mobilité permet de calculer la concentration en aluminium à partir des concentrations en bore et en phosphore.

$$[Al] = 5,57.10^{16} \ cm^{-3}$$

**Tableau 3**

|  | Procédé | GDMS |
|---|---|---|
| [B] | $1,11.10^{17}$ | $10^{17}$ |
| [Al] | $5,57.10^{16}$ | $6.10^{16}$ |
| [P] | $5,64.10^{16}$ | $5.10^{16}$ |

Les valeurs obtenues par le procédé de la figure 2 (étape F6) sont, à nouveau, proches de celles obtenues par l'analyse chimique GDMS.

Exemple 3

Ce dernier exemple concerne un échantillon en silicium de type n dopé au phosphore, au bore et à l'aluminium.

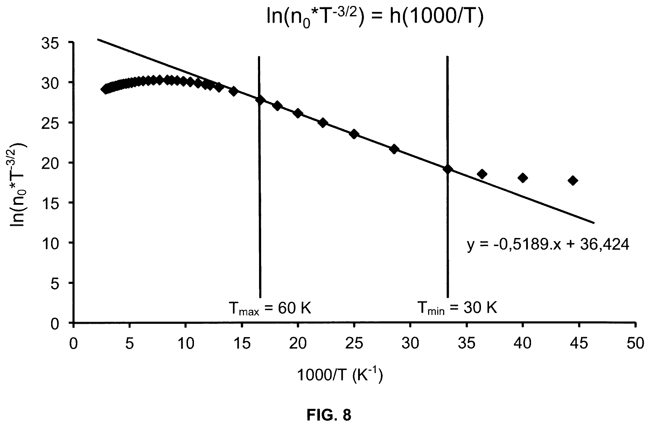

La concentration en électrons $n_0$ est mesurée par effet Hall entre 20 K et 350 K. Dans la plage 30 K-60 K, la fonction h telle que $\ln(p_0)*T^{-3/2} = h(1000/T)$ décrit une droite d'équation $y = -0,521.x + 36,46$ (Figure 8). L'énergie d'activation du phosphore (dopant majoritaire) vaut 44,6 meV, ce qui correspond au niveau d'énergie maximum constaté pour ce dopant.

La mobilité des électrons à 300 K est mesurée à 872 $cm^2.V^{-1}.s^{-1}$. La concentration en électrons à 300 K vaut $3,2.10^{16}$ $cm^{-3}$.

On en déduit les équations suivantes :

$$\ln\left[\left(\frac{1}{2}.N'_C.\left(\frac{[P]-[B]-[Al]}{[B]+[Al]}\right)\right)\right] = 36{,}46$$

$N_C$' est une densité d'état dans la bande de conduction dont la contribution en température a été supprimée par le tracé de $\ln(p_0*T^{-3/2})$ : $N_C = N'_C.T^{3/2}$ avec $N_C' = 5,4.10^{15}$ $cm^{-3}$.

$$\mu_{exp} = \mu_{min} + \frac{\mu_{max} - \mu_{min}}{1 + \left(\frac{N}{N_{réf}}\right)^{\alpha} + \left(\frac{C_l - 1}{C_{l,réf}}\right)^{\beta}} = 872\ cm^2.V^{-1}.s^{-1}$$

$$[P] - [B] - [Al] = 3,2.10^{16}\ cm^{-3}$$

**Tableau 4**

|      | Procédé | GDMS |
|------|---------|------|
| [P]  | $3,58.10^{16}$ | $4.10^{16}$ |
| [B]  | $6,8.10^{15}$ | $5.10^{15}$ |
| [Al] | $3,3.10^{15}$ | $3.10^{15}$ |

Le tableau 4 donne les concentrations en dopants obtenues en résolvant le système des trois équations ci-dessus. Ainsi, pour le type n, comme pour le type p, les valeurs obtenues par le procédé de détermination sont en accord avec celles de la technique classique GDMS.

## Revendications

**1.** Procédé de détermination de concentrations en dopants dans un échantillon en matériau semi-conducteur, l'échantillon comportant trois dopants ($N_{AF}$, $N_{AP}$, $N_D$) dont un de type majoritaire et un de type minoritaire, deux dopants d'un même type ayant des énergies d'activation différentes ($E_{AF}$, $E_{AP}$), procédé comprenant les étapes suivantes :

- mesurer (F1) la concentration ($p_0$) en porteurs de charge libres dans l'échantillon à des première et deuxième températures pour lesquelles le dopant du type majoritaire ($N_{AF}$) ayant la plus faible énergie d'activation ($E_{AF}$) est dans un régime d'ionisation ;
- confronter (F2) les mesures de la concentration ($p_0$) en porteurs de charge libres avec un modèle mathématique de la concentration ($p_0$) en porteurs de charge libres en fonction de la température (T) dans le régime d'ionisation ;
- déterminer la valeur de l'énergie d'activation ($E_{AF}$) du dopant de type majoritaire ayant la plus faible énergie d'activation ($E_{AF}$) et établir une première équation (R1) entre les concentrations en dopants ($N_{AF}$, $N_{AP}$, $N_D$), à partir des paramètres du modèle mathématique ;
- déterminer (F3) une valeur expérimentale de la mobilité ($\mu_{exp}$) des porteurs de charges majoritaires dans l'échantillon ;
- comparer (F4) la valeur expérimentale de mobilité ($\mu_{exp}$) des porteurs de charges majoritaires à une expression mathématique ($\mu_{th}$) de la mobilité, de sorte à établir une deuxième équation (R2) entre les concentrations en dopants ;
- comparer (F5) la valeur de l'énergie d'activation ($E_{AF}$) du dopant de type majoritaire ayant la plus faible énergie d'activation ($E_{AF}$) à une valeur seuil ($E_{AFmax}$) de l'énergie d'activation pour ledit dopant ;
- déterminer (F6) les trois concentrations en dopants ($N_{AF}$, $N_{AP}$, $N_D$) à partir de ladite valeur d'énergie d'activation ($E_{AF}$), et des première (R1, R1') et deuxième (R2) équations, lorsque ladite valeur d'énergie d'activation ($E_{AF}$) est inférieure à la valeur seuil ($E_{AFmax}$) ; ou
- déterminer (F6') les trois concentrations en dopants à partir des première et deuxième équations, d'une troisième équation (R3) dérivée de l'électro-neutralité dans le matériau semi-conducteur à température ambiante et de la concentration ($p_0$) en porteurs de charge libres mesurée à température ambiante, lorsque ladite valeur d'énergie d'activation ($E_{AF}$) est égale à la valeur seuil ($E_{AFmax}$).

2. Procédé selon la revendication 1, dans lequel le modèle de la concentration ($p_0$) en porteurs de charge libres en fonction de la température (T) dans le régime d'ionisation est une loi d'Arrhenius.

3. Procédé selon la revendication 2, dans lequel l'échantillon en matériau semi-conducteur comporte deux dopants majoritaires et un dopant minoritaire, et dans lequel le modèle de la concentration ($p_0$) en porteurs de charge libres s'écrit :

$$p_0(T) = C.\left[\frac{N_{MF} - N_m}{N_m}\right].e^{\frac{-E_{MF}}{kT}}$$

avec C un coefficient représentatif d'un type de conductivité des dopants majoritaires, $N_{MF}$ la concentration du dopant majoritaire dont l'énergie d'activation, $E_{MF}$, est la plus faible, $N_m$ la concentration du dopant minoritaire dans l'échantillon, k la constante de Boltzmann et T la température.

4. Procédé selon la revendication 2, dans lequel l'échantillon en matériau semi-conducteur comporte deux dopants minoritaires et un dopant majoritaire, et dans lequel le modèle de la concentration ($p_0$) en porteurs de charge libres s'écrit :

$$p_0(T) = C.\left[\frac{N_M - (N_{m1} + N_{m2})}{(N_{m1} + N_{m2})}\right].e^{\frac{-E_M}{kT}}$$

avec C un coefficient représentatif d'un type de conductivité du dopant majoritaire, $N_M$ la concentration du dopant majoritaire dans l'échantillon, $E_M$ l'énergie d'activation du dopant majoritaire, $N_{m1}$, $N_{m2}$ les concentrations des deux dopants minoritaires dans l'échantillon, k la constante de Boltzmann et T la température.

5. Procédé selon l'une quelconque des revendications 2 à 4, comprenant les étapes suivantes :

- calculer le logarithme de la concentration ($p_0$) en porteurs de charge libres en fonction de l'inverse de la température (T), à partir des mesures de la concentration en porteurs de charge libres,
- calculer l'équation d'une droite représentant le logarithme de la concentration ($p_0$) en porteurs de charge libres dans le régime d'ionisation ;
- déterminer la valeur de l'énergie d'activation ($E_{AF}$) du dopant de type majoritaire ayant la plus faible énergie d'activation ($E_{AF}$) à partir de la pente de la droite et déterminer la première équation (R1) entre les concentrations en dopants ($N_{AF}$, $N_{AP}$, $N_D$) à partir de l'ordonnée à l'origine de la droite.

6. Procédé selon l'une quelconque des revendications 1 à 5, dans lequel la valeur expérimentale de la mobilité ($\mu_{exp}$) est déterminée à partir de la résistivité ($\rho_{exp}$) de l'échantillon mesurée à une troisième température et de la concentration ($p_0$) en porteurs de charge libres mesurée à la troisième température.

7. Procédé selon la revendication 6, dans lequel la résistivité ($\rho$) est mesurée par la méthode de Van der Pauw.

8. Procédé selon l'une quelconque des revendications 1 à 7, dans lequel la concentration ($p_0$) en porteurs de charge libres est mesurée simultanément par effet Hall.

**Patentansprüche**

1. Verfahren zur Bestimmung von Konzentrationen an Dotierungssubstanzen in einem Probestück aus Halbleiter-Material, wobei das Probestück drei Dotierungssubstanzen ($N_{AF}$, $N_{AP}$, $N_D$) enthält, davon eine Majoritätsdotierungssubstanz und eine Minoritätsdotierungssubstanz, wobei zwei Dotierungssubstanzen des gleichen Typs unterschiedliche Aktivierungsenergien ($E_{AF}$, $E_{AP}$) besitzen,
bestehend aus folgenden Verfahrensschritten:

   - Messen (F1) der Konzentration ($p_0$) an freien Ladungsträgern in dem Probestück bei einer ersten und einer zweiten Temperatur, bei denen die Majoritätsdotierungssubstanz ($N_{AF}$) mit der geringeren Aktivierungsenergie ($E_{AF}$) sich in einem Ionisierungszustand befindet;
   - Konfrontieren (F2) der Messungen der Konzentration ($p_0$) an freien Ladungsträgern mit einem mathematischen Modell der Konzentration ($p_0$) an freien Ladungsträgern in Abhängigkeit von der Temperatur (T) im Ionisierungszustand;
   - Bestimmen des Werts der Aktivierungsenergie ($E_{AF}$) der Majoritätsdotierungssubstanz mit der geringeren Aktivierungsenergie ($E_{AF}$) und Aufstellen einer ersten Gleichung (R1) zwischen den Konzentrationen an Dotierungssubstanzen ($N_{AF}$, $N_{AP}$, $N_D$) aus Parametern des mathematischen Modells;
   - Bestimmen (F3) eines Versuchswerts der Beweglichkeit ($\mu_{exp}$) der Majoritätsladungsträger in dem Probestück;
   - Vergleichen (F4) des Versuchswerts der Beweglichkeit ($\mu_{exp}$) der Majoritätsladungsträger mit einem mathematischen Ausdruck ($\mu_{th}$) der Beweglichkeit dergestalt, dass eine zweite Gleichung (R2) zwischen den Konzentrationen an Dotierungssubstanzen aufgestellt wird;
   - Vergleichen (F5) des Werts der Aktivierungsenergie ($E_{AF}$) der Majoritätsdotierungssubstanz mit der geringeren Aktivierungsenergie ($E_{AF}$) mit einem Schwellenwert ($E_{AFmax}$) der Aktivierungsenergie für die genannte Dotierungssubstanz;
   - Bestimmen (F6) der drei Konzentrationen an Dotierungssubstanzen ($N_{AF}$, $N_{AP}$, $N_D$) aus dem genannten Wert der Aktivierungsenergie ($E_{AF}$) und der ersten Gleichung (R1, R1') und zweiten Gleichung (R2), wenn der genannte Wert der Aktivierungsenergie ($E_{AF}$) unter dem Schwellenwert ($E_{AFmax}$) liegt; oder
   - Bestimmen (F6') der drei Konzentrationen an Dotierungssubstanzen aus der ersten und zweiten Gleichung, einer dritten Gleichung (R3), die von der Elektroneutralität in dem Halbleiter-Material bei Umgebungstemperatur abgeleitet ist, sowie aus der Konzentration ($p_0$) an freien Ladungsträgern, gemessen bei Umgebungstemperatur, wenn der genannte Wert der Aktivierungsenergie ($E_{AF}$) gleich dem Schwellenwert ($E_{AFmax}$) ist.

2. Verfahren nach Anspruch 1, wobei das Modell der Konzentration ($p_0$) an freien Ladungsträgern in Abhängigkeit von der Temperatur (T) im Ionisierungszustand ein Arrhenius-Modell ist.

3. Verfahren nach Anspruch 2, wobei das Probestück aus Halbleiter-Material zwei Majoritätsdotierungssubstanzen und eine Minoritätsdotierungssubstanz enthält, und wobei das Modell der Konzentration ($p_0$) an freien Ladungsträgern folgendermaßen ausgedrückt wird:

$$p_0(T) = C.\left[\frac{N_{MF} - N_m}{N_m}\right].e^{\frac{-E_{MF}}{kT}}$$

mit C ein Koeffizient, der einen Leitfähigkeitstyp der Majoritätsdotierungssubstanzen darstellt, mit $N_{MF}$ die Konzentration der Majoritätsdotierungssubstanz mit der geringeren Aktivierungsenergie $E_{MF}$, mit $N_m$ die Konzentration der Minoritätsdotierungssubstanz in dem Probestück, mit k die Boltzmann-Konstante und mit T die Temperatur.

4. Verfahren nach Anspruch 2, wobei das Probestück aus Halbleiter-Material zwei Minoritätsdotierungssubstanzen und eine Majoritätsdotierungssubstanz enthält, und wobei das Modell der Konzentration ($p_0$) an freien Ladungsträgern folgendermaßen ausgedrückt wird:

$$p_0(T) = C.\left[\frac{N_M - (N_{m1} + N_{m2})}{(N_{m1} + N_{m2})}\right].e^{\frac{-E_M}{kT}}$$

mit C ein Koeffizient, der einen Leitfähigkeitstyp der Majoritätsdotierungssubstanz darstellt, mit $N_M$ die Konzentration der Majoritätsdotierungssubstanz im Probestück, mit $E_M$ die Aktivierungsenergie der Majoritätsdotierungssubstanz, mit $N_{m1}$, $N_{m2}$ die Konzentrationen der beiden Minoritätsdotierungssubstanzen in dem Probestück, mit k die Boltzmann-Konstante und mit T die Temperatur.

5. Verfahren nach einem der Ansprüche 2 bis 4, das die folgenden Verfahrensschritte umfasst:

- Berechnen des Logarithmus der Konzentration ($p_0$) an freien Ladungsträgern in Abhängigkeit von dem Umkehrwert der Temperatur (T), aus den Messungen der Konzentration an freien Ladungsträgern,
- Berechnen der Gleichung einer Geraden, die den Logarithmus der Konzentration ($p_0$) an freien Ladungsträgern im Ionisierungszustand darstellt,
- Bestimmen des Werts der Aktivierungsenergie ($E_{AF}$) der Majoritätsdotierungssubstanz mit der geringeren Aktivierungsenergie ($E_{AF}$) aus der Steigung der Geraden, und Bestimmen der ersten Gleichung (R1) zwischen den Konzentrationen an Dotierungssubstanzen ($N_{AF}$, $N_{AP}$, $N_D$) aus der Ordinate am Anfangspunkt der Geraden.

6. Verfahren nach einem der Ansprüche 1 bis 5, wobei der Versuchswert der Beweglichkeit ($\mu_{exp}$) aus dem spezifischen Widerstand ($p_{exp}$) des Probestücks, gemessen bei einer dritten Temperatur, und aus der Konzentration ($p_0$) an freien Ladungsträgern, gemessen bei der dritten Temperatur, bestimmt wird.

7. Verfahren nach Anspruch 6, wobei der spezifische Widerstand (p) mit der Van-der-Pauw-Messmethode gemessen wird.

8. Verfahren nach einem der Ansprüche 1 bis 7, wobei die Konzentration ($p_0$) an freien Ladungsträgern gleichzeitig mittels Hall-Effekt gemessen wird.

**Claims**

1. A method for determining dopant concentrations in a semiconductor material sample, the sample comprising three dopants ($N_{AF}$, $N_{AP}$, $N_D$) one of which is of majority type and one of minority type, two dopants of the same type having different activation energies ($E_{AF}$, $E_{AP}$),
   the method comprising the following steps:

   - measuring (F1) the free charge carrier concentration ($p_0$) in the sample at first and second temperatures for which the dopant of majority type ($N_{AF}$) having the weakest activation energy ($E_{AF}$) is in an ionization state;
   - confronting (F2) the measurements of the free charge carrier concentration ($p_0$) with a mathematical model of the free charge carrier concentration ($p_0$) versus the temperature (T) in the ionization state;
   - determining the value of the activation energy ($E_{AF}$) of the dopant of majority type having the weakest activation energy ($E_{AF}$) and establishing a first equation (R1) between the dopant concentrations ($N_{AF}$, $N_{AP}$, $N_D$) from parameters of the mathematical model;
   - determining (F3) an experimental value of the mobility ($\mu_{exp}$) of the majority charge carriers in the sample;
   - comparing (F4) the experimental value of the mobility ($\mu_{exp}$) of the majority charge carriers with a mathematical expression ($\mu_{th}$) of the mobility so as to establish a second equation (R2) between the dopant concentrations;
   - comparing (F5) the value of the activation energy ($E_{AF}$) of the dopant of majority type having the weakest activation energy ($E_{AF}$) with a threshold value ($E_{AFmax}$) of the activation energy for said dopant;
   - determining (F6) the three dopant concentrations ($N_{AF}$, $N_{AP}$, $N_D$) from said activation energy value ($E_{AF}$), and from the first (R1, R1') and second (R2) equations, when said activation energy value ($E_{AF}$) is lower than the threshold value ($E_{AFmax}$); or
   - determining (F6') the three dopant concentrations from the first and second equations, from a third equation (R3) derived from the electro-neutrality in the semiconductor material at ambient temperature and from the free charge carrier concentration ($p_0$) measured at ambient temperature, when said activation energy value ($E_{AF}$) is equal to the threshold value.

2. The method according to claim 1, wherein the model of the free charge carrier concentration ($p_0$) versus the temperature (T) in the ionization state is an Arrhenius law.

3. The method according to claim 2, wherein the semiconductor material sample comprises two majority dopants and one minority dopant, and wherein the model of the free charge carrier concentration ($p_0$) is written:

$$p_0(T) = C.\left[\frac{N_{MF} - N_m}{N_m}\right].e^{\frac{-E_{MF}}{kT}}$$

with C a coefficient representative of a type of conductivity of the majority dopants, $N_{MF}$ the concentration of the majority dopant having the weakest activation energy $E_{MF}$, $N_m$ the concentration of the minority dopant in the sample, k the Boltzmann's constant and T the temperature.

4. The method according to claim 2, wherein the semiconductor material sample comprises two minority dopants and one majority dopant, and wherein the model of the free charge carrier concentration ($p_0$) is written:

$$p_0(T) = C.\left[\frac{N_M - (N_{m1} + N_{m2})}{(N_{m1} + N_{m2})}\right].e^{\frac{-E_M}{kT}}$$

with C a coefficient representative of a type of conductivity of the majority dopant, $N_M$ the concentration of the majority dopant in the sample, $E_M$ the activation energy of the majority dopant, $N_{m1}$ and $N_{m2}$ the concentrations of the two minority dopants in the sample, k the Boltzmann's constant and T the temperature.

5. The method according to any one of claims 2 to 4, comprising the following steps:

   - calculating the logarithm of the free charge carrier concentration ($p_0$) versus the inverse of the temperature (T) from measurements of the free charge carrier concentration,
   - calculating the equation of a line representing the logarithm of the free charge carrier concentration ($p_0$) in the ionization state;
   - determining the value of the activation energy ($E_{AF}$) of the dopant of majority type having the weakest activation energy ($E_{AF}$) from the slope of the line and determining the equation (R1) between the dopant concentrations ($N_{AF}$, $N_{AP}$, $N_D$) from the y-axis at the origin of the line.

6. The method according to one of claims 1 to 5, wherein the experimental value of the mobility ($\mu_{exp}$) is determined from the resistivity ($\rho_{exp}$) of the sample measured at a third temperature and from the free charge carrier concentration ($p_0$) measured at the third temperature.

7. The method according to claim 6, wherein the resistivity (p) is measured by the Van der Pauw method.

8. The method according to any one of claims 1 to 7, wherein the free charge carrier concentration ($p_0$) is simultaneously measured by Hall effect.

FIG. 1

Mesurer la concentration $p_0$ en porteurs de charge libres à basse température T (régime d'ionisation du dopant majoritaire le moins profond) — F1

Confronter les mesures de la concentration $p_0$ avec un modèle $p_0$(T) pour le régime d'ionisation et en déduire l'énergie d'activation $E_{AF}$ et une première équation R1 entre les concentrations en dopants $N_{AF}$ et $N_D$ — F2

Déterminer la mobilité $\mu_{exp}$ des porteurs de charge majoritaires — F3

Comparer la mobilité $\mu_{exp}$ à une expression mathématique $\mu_{th}$ et en déduire une deuxième équation R2 entre les concentrations en dopants $N_{AF}$, $N_{AP}$ et $N_D$ — F4

F5

$E_{AF} = E_{AFmax}$

NON

OUI

Déterminer $N_{AF}$ à partir de $E_{AF}$ et d'un abaque et déterminer $N_{AP}$, $N_D$ à partir des équations R1, R2 et de $N_{AF}$

F6

Déterminer $N_{AF}$, $N_{AP}$ et $N_D$ à partir des équations R1, R2 et d'une équation R3 dérivée de l'électro-neutralité :

$$p_0 = N_{AF} + N_{AP} - N_D$$

F6'

**FIG. 2**

F2

Calculer ln($p_0$) en fonction de 1/T ——— F21

Calculer l'équation f(1/T) de la droite obtenue à basse température ——— F22

Déterminer l'équation R1 à partir de l'ordonnée à l'origine f(0) de la droite : ——— F23

$$f(0) = \frac{1}{4} \cdot N_V \cdot \left[ \frac{N_{AF} - N_D}{N_D} \right]$$

Calculer l'énergie d'activation $E_{AF}$ à partir de la pente de la droite ——— F24

**FIG. 3**

FIG. 4

Mesurer la concentration $p_0$ en porteurs de charge libres à basse température T (régime d'ionisation du dopant majoritaire) — F1

Confronter les mesures de la concentration $p_0$ avec un modèle $p_0(T)$ pour le régime d'ionisation et en déduire l'énergie d'activation $E_A$ et une première équation R1 entre les concentrations en dopants $N_A$, $N_{DF}$ et $N_{DP}$ — F2

Déterminer la mobilité $\mu_{exp}$ des porteurs de charge majoritaires — F3

Comparer la mobilité $\mu_{exp}$ à une expression mathématique $\mu_{th}$ et en déduire une deuxième équation R2 entre les concentrations en dopants $N_A$, $N_{DF}$ et $N_{DP}$ — F4

F5

$E_A = E_{Amax}$

NON                OUI

Déterminer $N_A$ à partir de $E_A$ et d'un abaque et déterminer $N_{DP}$, $N_{DF}$ à partir des équations R1, R2 et de $N_A$

F6

Déterminer $N_A$, $N_{DP}$ et $N_{DF}$ à partir des équations R1, R2 et d'une équation R3 dérivée de l'électro-neutralité :

$$p_0 = N_A - N_{DF} - N_{DP}$$

F6'

**FIG. 5**

$$\ln(p_0 \cdot T^{-3/2}) = g(1000/T)$$

$T_{max} = 99{,}5\ K$      $T_{min} = 54{,}5\ K$

$y = -0{,}5117.x + 33{,}056$

1000/T (K$^{-1}$)

**FIG. 6**

$$\ln(p_0 \cdot T^{-3/2}) = g(1000/T)$$

$T_{max} = 76\ K$      $T_{min} = 40\ K$

$y = -0{,}4863.x$

1000/T (K$^{-1}$)

**FIG. 7**

$$\ln(n_0 * T^{-3/2}) = h(1000/T)$$

FIG. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2978548

- FR 2978549

**Littérature non-brevet citée dans la description**

- **B. DREVET et al.** Ségrégation and crystallization of purified metallurgical grade silicon : Influence of process parameters on yield and solar cell efficiency. *25th European PV Solar Energy Conférence and Exhibition,* 2010
- **G. E. STILLMAN et al.** Electrical characterization of epitaxial layers. *Thin Solid Films,* 1976, vol. 31, 69-88

- **F. SCHINDLER et al.** Modeling majority carrier mobility in compensated crystalline silicon for solar cells. *Solar Energy Materials & Solar Cells,* 2012, vol. 106, 31-36
- **P.P. ALTERMATT et al.** A simulation model for the density of states and for incomplète ionization in crystalline silicon - Part II. *J. Appl. Phys.,* 2006, vol. 100, 113715